# EUROPÄISCHE PATENTANMELDUNG

(11) **EP 1 681 711 A1**
(43) Veröffentlichungstag der Anmeldung: **19.07.2006**
(21) Anmeldenummer: 05028214.4
(22) Anmeldetag: 22.12.2005
(51) Int. Cl.: H01L 21/20, C30B 29/52

(54) **Halbleiterscheibe mit Silicium-Germanium-Schicht und Verfahren zu deren Herstellung**

(30) Priorität: 05.01.2005 DE 102005000826
(71) Anmelder: Siltronic AG, 81737 München (DE)
(72) Erfinder: Dantz, Dirk, Dr., 38154 Königslutter am Elm (DE); Huber, Andreas, Dr., 84518 Garching (DE); Wahlich, Reinhold, 84529 Tittmoning (DE)
(74) Vertreter: Baar, Christian

(57) **Zusammenfassung**

Die Erfindung bezieht sich auf eine Halbleiterscheibe, umfassend eine monokristalline Siliciumschicht und eine daran angrenzende gradierte Silicium-Germanium-Schicht der Dicke d mit einer Zusammensetzung Si₁₋ₓGeₓ, wobei x für den Stoffmengenanteil des Germaniums steht und für x die Bedingung 0 < x ≤ 1 gilt und wobei x mit zunehmendem Abstand a von der monokristallinen Siliciumschicht größere Werte annimmt, dadurch gekennzeichnet, dass zwischen dem Stoffmengenanteil x(d) des Germaniums an der Oberfläche der gradierten Silicium-Germanium-Schicht und dem Stoffmengenanteil x(d/2) des Germaniums in der Mitte des Abstands zwischen der monokristallinen Siliciumschicht und der Oberfläche der gradierten Silicium-Germanium-Schicht folgender Zusammenhang besteht: x(d/2) > 0,5·x(d).

Gegenstand der Erfindung ist auch die Weiterverarbeitung der Halbleiterscheibe, wobei eine Schicht der Halbleiterscheibe auf eine Trägerscheibe übertragen wird sowie die damit hergestellten Halbleiterscheibe.

## Beschreibung

Die Erfindung betrifft eine Halbleiterscheibe umfassend eine monokristalline Siliciumschicht und eine daran angrenzende Silicium-Germanium-Schicht, bei der der Stoffmengenanteil des Germaniums zur Oberfläche hin ansteigt, sowie ein Verfahren zur Herstellung der Halbleiterscheibe. Gegenstand der Erfindung ist auch die Weiterverarbeitung der Halbleiterscheibe, wobei eine Schicht der Halbleiterscheibe auf eine Trägerscheibe übertragen wird sowie die damit hergestellten Halbleiterscheiben.

Bei einem bekannten Verfahren für die Herstellung relaxierter Silicium-Germanium-Schichten wird zunächst durch Abscheidung von Silicium-Germanium-Schichten mit zunehmendem Germanium-Gehalt (im Folgenden als "gradierte Silicium-Germanium-Schicht" bezeichnet) eine Gitteranpassung zwischen Silicium und Silicium-Germanium erreicht. Das Profil der Germanium-Konzentration wird im Stand der Technik entweder als "linear" oder "stufenförmig" beschrieben. Die darauf folgende Silicium-Germanium-Schicht mit konstantem Stoffmengenanteil des Germaniums dient zur mechanischen Entspannung der Silicium-Germanium-Schicht. Optional können die bei diesem Verfahren auftretenden Oberflächenrauhigkeiten durch nachfolgende und/oder zwischengeschaltete Polierschritte reduziert werden.

Gemäß dem Stand der Technik, siehe zum Beispiel US6593625 oder US6107653, wird das Profil des Stoffmengenanteils des Germaniums in der gradierten Zwischenschicht als "linear" oder "stufenförmig" beschrieben. Diese gradierten Silicium-Germanium-Schichten weisen an ihrer Oberfläche Versetzungsdichten von 10⁶ bis 10⁷ cm⁻² auf. Wird auf der Silicium-Germanium-Schicht eine verspannte Siliciumschicht abgeschieden, so weist diese eine ähnliche Versetzungsdichte auf. Wird die Silicium-Germanium-Schicht oder die verspannte Siliciumschicht auf eine Trägerscheibe übertragen, um ein SGOI-Substrat ("silicon-germanium on insulator") oder ein sSOI-Substrat ("strained silicon on insulator") herzustellen, so weist die übertragene Schicht ebenfalls eine Versetzungsdichte im genannten Bereich auf. Diese Versetzungsdichte ist so hoch, dass sie sich nachteilig auf die elektronischen Eigenschaften der auf diesen Substraten hergestellten elektronischen Bauelemente auswirkt. Auch nach Planarisierung der gradierten Silicium-Germanium-Schicht, beispielsweise durch chemischmechanische Politur (CMP), wie in US6107653 offenbart, liegt die Versetzungsdichte im oberen Bereich der Silicium-Germanium-Schicht im Bereich von 10⁵ cm⁻².

Aufgabe der Erfindung war es daher, die Versetzungsdichten in gradierten Silicium-Germanium-Schichten zu reduzieren.

Die Aufgabe wird gelöst durch eine Halbleiterscheibe umfassend eine monokristalline Siliciumschicht und eine daran angrenzende gradierte Silicium-Germanium-Schicht der Dicke d mit einer Zusammensetzung Si₁₋ₓGeₓ, wobei x für den Stoffmengenanteil des Germaniums steht und für x die Bedingung 0 < x ≤ 1 gilt und wobei x mit zunehmendem Abstand a von der monokristallinen Siliciumschicht größere Werte annimmt, dadurch gekennzeichnet, dass zwischen dem Stoffmengenanteil x(d) des Germaniums an der Oberfläche der gradierten Silicium-Germanium-Schicht und dem Stoffmengenanteil x(d/2) des Germaniums in der Mitte des Abstands zwischen der monokristallinen Siliciumschicht und der Oberfläche der gradierten Silicium-Germanium-Schicht folgender Zusammenhang besteht: x(d/2) > 0,5·x(d).

Erfindungsgemäß erfolgt der Anstieg des Stoffmengenanteils x des Germaniums mit zunehmendem Abstand a zur monokristallinen Siliciumschicht somit nicht linear oder gleich bleibend stufenförmig (d. h. mit gleichen Konzentrationssprüngen nach gleich bleibenden Schichtdicken, wie beispielsweise in US6107653 offenbart), sondern mit abnehmender Steigung. Vorzugsweise beginnt man mit der Abscheidung von reinem Silicium auf der Oberfläche der monokristallinen Siliciumschicht. Die Siliciumschicht kann entweder eine dünne Schicht auf einem geeigneten Trägermaterial sein oder, was bevorzugt ist, eine monokristalline Siliciumscheibe. Zu Beginn der Abscheidung der gradierten Silicium-Germanium-Schicht steigt der Stoffmengenanteil des Germaniums erfindungsgemäß relativ rasch, wohingegen die Steigung mit steigendem Germanium-Gehalt, d. h. mit zunehmender Entfernung zur monokristallinen Siliciumschicht bzw. zum Ende der Abscheidung hin, abnimmt. Dieser Sachverhalt wird durch den Zusammenhang x(d/2) > 0,5·x(d) ausgedrückt. Am Ort der halben Dicke der gradierten Silicium-Germanium-Schicht ist der Stoffmengenanteil des Germaniums also schon höher als es bei einem linearen Gradienten der Fall wäre, da der Stoffmengenanteil des Germaniums zunächst vergleichsweise steil und im weiteren Verlauf flacher ansteigt. Vorzugsweise weicht der Verlauf des Stoffmengenanteils des Germaniums sogar so weit vom linearen Gradienten ab, dass die Ungleichung x(d/2) > 0,6·x(d) erfüllt ist.

Dadurch werden in den ersten, d. h. untersten Schichten der gradierten Silicium-Germanium-Schicht höhere Spannungen und damit auch im Vergleich zur konventionellen linearen Gradierung höhere Versetzungsdichten erzeugt, die dann im weiteren Verlauf in den Schichten mit vergleichsweise geringeren Änderungen in der Zusammensetzung abgebaut werden können. In Folge der späteren flacheren Gradierung entstehen nahe der Oberfläche nur noch wenige zusätzliche Versetzungen, was schließlich zu einer stark reduzierten Versetzungsdichte führt. Das Anpassen des Konzentrationsgradienten an die aus der Schichtstruktur entstehenden mechanischen Belastungen bietet die Möglichkeit, die infolge der Gitterfehlanpassung vorliegenden Spannungen soweit zu beeinflussen, dass die Ausbildung von Versetzungen insgesamt minimiert und auf Bereiche beschränkt wird, in denen sie für die Folgeprozesse und Folgeanwendungen keine oder weit geringere negative Auswirkungen haben. Erfindungsgemäß wird somit bei gleicher Gesamtdicke der gradierten Silicium-Germanium-Schicht eine geringere Versetzungsdichte an der Oberfläche erreicht als gemäß dem Stand der Technik, d. h. die Qualität der Silicium-Germanium-Oberfläche wird verbessert. Andererseits kann bei vorgegebener Versetzungsdichte die Gesamtdicke der gradierten Silicium-Germanium-Schicht gegenüber dem Stand der Technik reduziert werden, was die Wirtschaftlichkeit der Herstellung erhöht.

Die Gesamtdicke d der gradierten Silicium-Germanium-Schicht beträgt vorzugsweise 0,5 bis 10 µm, besonders bevorzugt 1 bis 5 µm.

Eine ggf. auf der gradierten Silicium-Germanium-Schicht abgeschiedene zusätzliche Silicium-Germanium-Schicht mit konstantem Stoffmengenanteil des Germaniums wird erfindungsgemäß nicht als Teil der gradierten Silicium-Germanium-Schicht betrachtet. Für die erfindungsgemäße gradierte Silicium-Germanium-Schicht ist also in jedem Fall zusätzlich zu den oben angegebenen Ungleichungen der Zusammenhang x(d/2) < x(d) erfüllt, vorzugsweise sogar x(d/2) < 0,9·x(d) und besonders bevorzugt x(d/2) < 0,85·x(d).

Zusammengenommen ist also insbesondere ein Zusammenhang von 0,9·x(d) > x(d/2) > 0,5·x(d) bevorzugt und ein Zusammenhang von 0,85·x(d) > x(d/2) > 0,6·x(d) besonders bevorzugt.

Erfindungsgemäß wird an der Oberfläche der abgeschiedenen gradierten Silicium-Germanium-Schicht eine Versetzungsdichte von weniger als 1.10⁴ cm⁻² erreicht. Mit dem erfindungsgemäßen Verfahren können somit sehr niedrige Versetzungsdichten bis hin zu 100 cm⁻² oder sogar 10 cm⁻² erreicht werden.

Die Aufgabe wird auch gelöst durch ein Verfahren zur Herstellung einer erfindungsgemäßen Halbleiterscheibe, wobei auf einer Halbleiterscheibe umfassend eine monokristalline Siliciumschicht Silicium-Germanium mit einer Zusammensetzung Si₁₋ₓGeₓ, wobei x für den Stoffmengenanteil des Germaniums steht und für x die Bedingung 0 < x ≤ 1 gilt, epitaktisch abgeschieden wird, wobei x mit zunehmender Dicke der abgeschiedenen Schicht größere Werte annimmt, dadurch gekennzeichnet, dass sich der Anstieg von x mit zunehmender Dicke der abgeschiedenen Schicht verlangsamt.

Verfahren zur Abscheidung gradierter Silicium-Germanium-Schichten sind im Stand der Technik bekannt. Unter Beachtung der Bedingung, dass sich der Anstieg des Stoffmengenanteils x des Germaniums mit zunehmender Dicke der abgeschiedenen Silicium-Germanium-Schicht verlangsamt, wird die Abscheidung der gradierten Silicium-Germanium-Schicht beispielsweise so durchgeführt, wie in US6107653 beschrieben ist.

### Kurzbeschreibung der Figuren:

In den Figuren 1 bis 4 sind verschiedene Konzentrationsverläufe in der gradierten Zwischenschicht dargestellt. Es ist jeweils der Stoffmengenanteil x des Germaniums gegen den Abstand a von der monokristallinen Siliciumschicht aufgetragen.

Fig. 1 zeigt ein Beispiel für ein erfindungsgemäßes Profil des Stoffmengenanteils x des Germaniums mit abnehmender Steigung bei wachsendem Abstand a zur monokristallinen Siliciumschicht, beschreibbar mit einer stetig differenzierbaren Funktion.

Fig. 2 zeigt ein Beispiel für ein erfindungsgemäßes Profil des Stoffmengenanteils x des Germaniums mit abnehmender Steigung bei wachsender Entfernung zur monokristallinen Siliciumschicht, beschreibbar mit einer nicht stetig differenzierbaren Stufenfunktion, wobei die Einzelschichten eine gleich bleibende Dicke aufweisen und die Höhe der Stufen von einer Schicht zur nächsten abnimmt.

Fig. 3 zeigt ein Beispiel für eine stetige Änderung des Stoffmengenanteils x des Germaniums mit abnehmender Steigung bei wachsender Konzentration, wobei der ansteigende Konzentrationsverlauf durch zwei dünne Schichten 1 mit niedrigerer Germanium-Konzentration unterbrochen wird.

Fig. 4 zeigt ein Beispiel ähnlich dem Stufenprofil von Fig. 2, wobei in die gradierte Silicium-Germanium-Schicht zusätzliche Pufferschichten 2 integriert sind.

Im Folgenden wird die Erfindung zusammen mit bevorzugten Ausführungsformen anhand der Figuren näher beschrieben.

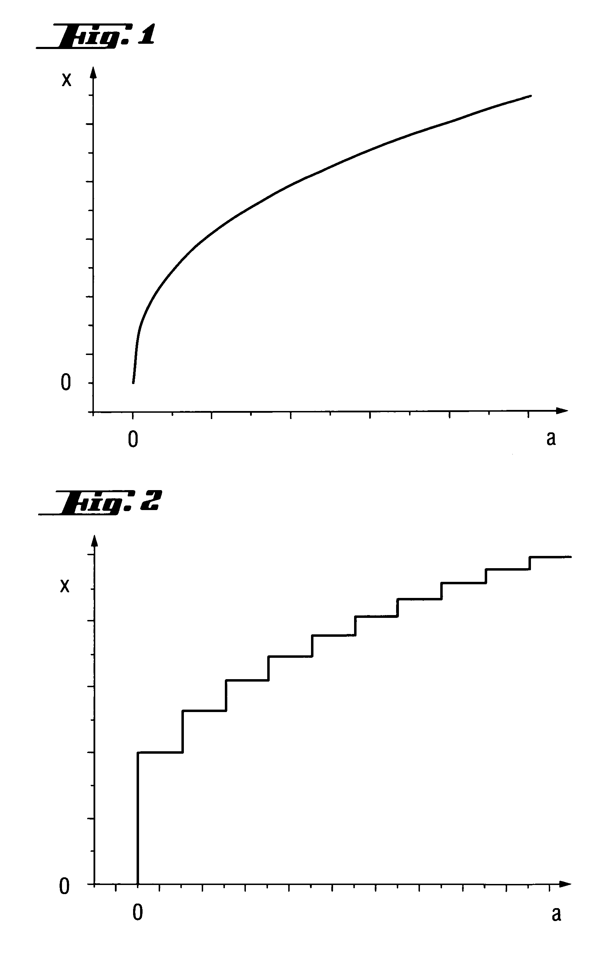

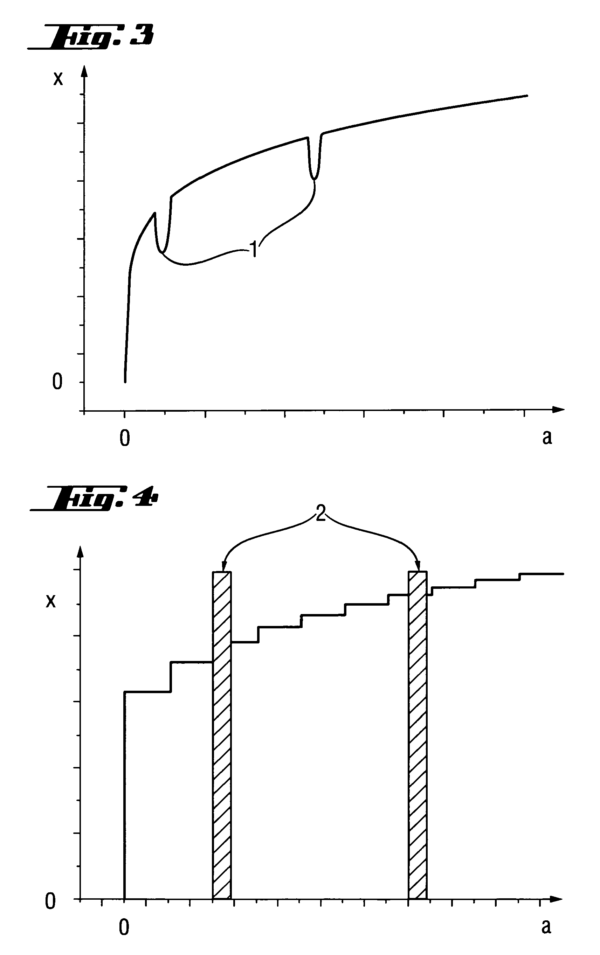

Die erfindungsgemäßen Konzentrationsprofile können auf unterschiedliche Weise realisiert werden. Den Konzentrationsverlauf beschreibende Funktionen können stetig differenzierbar sein (Fig. 1, 3). Dies bedeutet, dass die Abscheidung mit einer stetigen Änderung der Germanium-Konzentration erfolgt. Andererseits kann der erfindungsgemäße Konzentrationsverlauf auch durch eine nicht stetig differenzierbare Funktion (d. h. eine Stufenfunktion) repräsentiert werden (Fig. 2, 4). Bei diesem schichtweisen Aufbau kann die abnehmende Steigung der Germanium-Konzentration entweder durch eine konstante Änderung der Germanium-Konzentration der Einzelschichten bei zunehmender Dicke der Einzelschichten (nicht dargestellt) oder durch eine abnehmende Änderung der Germanium-Konzentration bei konstanter Dicke der Einzelschichten erreicht werden (Fig. 2, 4). Möglich ist auch eine Kombination dieser beiden Varianten.

In einer anderen bevorzugten Ausführungsform der Erfindung wird die erfindungsgemäße nicht-lineare Änderung der Zusammensetzung mit Zwischenschichten kombiniert, in denen die Germanium-Konzentration entgegen dem generellen Konzentrationsverlauf lokal in einer oder mehreren dünnen Schichten verändert wird.
Fig. 3 zeigt ein Beispiel, in dem der Stoffmengenanteil x des Germaniums in zwei dünnen Schichten 1 lokal begrenzt auf deutlich niedrigere Werte gesenkt wird. Infolge der hierdurch entstehenden Entspannung können zum einen bereits entstandene Versetzungen wieder abgebaut werden, zum anderen wird ein Weiterlaufen der Versetzungen in die folgenden Schichten verhindert. Es ist jedoch auch möglich, die Germanium-Konzentration lokal begrenzt auf deutlich höhere Werte zu erhöhen, sodass ein lokales Konzentrationsmaximum entsteht.

In einer weiteren Ausführungsform der Erfindung, die in Fig. 4 schematisch dargestellt ist, werden in die gradierte Silicium-Germanium-Schicht eine oder mehrere, vorzugsweise defektreiche, Pufferschichten 2 mit abweichender Zusammensetzung integriert, die den Konzentrationsverlauf unterbrechen. Diese Pufferschichten sind ebenfalls in der Lage, die infolge der Gitterfehlanpassung entstehenden Spannungen abzubauen und Versetzungen am Weiterlaufen zu hindern. Diese Schichten können beispielsweise aus Si_{1-x-y}GeₓC_{y} (mit 0 < x < 1, 0 < y < 1 und x+y < 1) bestehen.

In einer weiteren bevorzugten Ausführungsform der Erfindung wird auf der erfindungsgemäßen gradierten Schicht, in der der Stoffmengenanteil x des Germaniums mit zunehmendem Abstand a von der monokristallinen Siliciumschicht (a = 0) bis zu einem vorbestimmten Endwert ansteigt, der an der Oberfläche der gradierten Silicium-Germanium-Schicht (a = d) erreicht wird, zusätzlich eine Silicium-Germanium-Schicht mit konstantem Stoffmengenanteil des Germaniums abgeschieden, wobei der Germanium-Gehalt in dieser Deckschicht vorzugsweise dem Germanium-Gehalt des obersten Teils der gradierten Schicht entspricht. Die Deckschicht kann auch aus reinem Germanium bestehen, d. h. x = 1. Die Deckschicht weist erfindungsgemäß ebenfalls eine Versetzungsdichte an der Oberfläche von weniger als 1.10⁴ cm⁻² auf. Derartige Halbleiterscheiben werden bevorzugt als Donorscheibe zur Herstellung von SGOI-Scheiben verwendet. Diese Ausführungsform ist beliebig mit den verschiedenen Ausführungsformen der gradierten Zwischenschicht (stetig differenzierbarer Konzentrationsverlauf oder Stufenfunktion, mit oder ohne Schichten mit abweichender Germanium-Konzentration oder zusätzlichen Pufferschichten mit abweichender Zusammensetzung) kombinierbar.

Eine Ausführungsform der Erfindung sieht die Abscheidung einer verspannten Siliciumschicht auf der Silicium-Germanium-Schicht vor. Die verspannte Siliciumschicht ist bevorzugt 3 bis 20 nm dick. Die Abscheidung der verspannten Siliciumschicht kann auf jeder erfindungsgemäßen Silicium-Germanium-Schicht erfolgen. Die exakte Beschaffenheit der gradierten Silicium-Germanium-Schicht und eine eventuelle Anwesenheit einer Silicium-Germanium-Schicht mit konstanter Zusammensetzung sind dafür ohne Bedeutung. Die Oberfläche der Silicium-Germanium-Schicht, auf der die verspannte Siliciumschicht abgeschieden werden soll, ist vorzugsweise relaxiert und hat bevorzugt eine Zusammensetzung von 0,1 < x < 0,9, besonders bevorzugt von 0,1 < x < 0,5.

Alle erfindungsgemäßen Halbleiterscheiben können auch als Donorscheiben in einem Schichttransfer-Verfahren (engl. "layer transfer process") verwendet werden. Dazu wird die Halbleiterscheibe an der vorbereiteten Oberfläche, die die zu übertragende Schicht trägt, auf bekannte Art und Weise mit einer Trägerscheibe verbunden und anschließend die Dicke der Donorscheibe derart reduziert, dass nur mehr die zu übertragende Schicht auf der Trägerscheibe verbleibt. Verfahren zum Übertragen einer dünnen Halbleiterschicht auf eine Trägerscheibe sind beispielsweise in EP533551A1, WO98/52216A1 oder WO03/003430A2 beschrieben. Als Trägerscheibe wird beispielsweise eine elektrisch isolierende Scheibe (beispielsweise bestehend aus Quarz, Glas oder Saphir) verwendet oder die Oberfläche der Donorscheibe und/oder der Trägerscheibe wird vor dem Verbinden mit einer isolierenden Schicht, beispielsweise einer Oxidschicht versehen. Vorzugsweise wird als Trägerscheibe eine Siliciumscheibe, insbesondere eine monokristalline Siliciumscheibe verwendet, deren Oberfläche oxidiert wird, sodass eine Siliciumoxidschicht die elektrisch isolierende Schicht bildet. Verfahren zum Herstellen dieser isolierenden Schicht und zum Verbinden von Scheiben sind dem Fachmann bekannt. Die Verwendung erfindungsgemäßer Donorscheiben führt zu Versetzungsdichten in den übertragenen Schichten, die niedriger sind als gemäß dem Stand der Technik.

Soll eine Silicium-Germanium-Schicht auf eine Trägerscheibe übertragen werden, so wird eine erfindungsgemäße Halbleiterscheibe als Donorscheibe verwendet, deren Oberfläche einen Stoffmengenanteil x des Germaniums hat, der die Bedingung 0 < x < 1 erfüllt. Für diese Anwendung ist eine erfindungsgemäße Halbleiterscheibe mit einer zusätzlichen Silicium-Germanium-Schicht (Deckschicht) mit konstantem Stoffmengenanteil des Germaniums bevorzugt. Der Stoffmengenanteil des Germaniums liegt vorzugsweise im Bereich 0,1 < x < 0,9, besonders bevorzugt im Bereich 0,1 < x < 0,5. Soll insbesondere eine SGOI-Scheibe ("silicon-germanium on insulator") hergestellt werden, so wird als Trägerscheibe eine elektrisch isolierende Scheibe verwendet oder die Oberfläche der Donorscheibe und/oder der Trägerscheibe wird vor dem Verbinden mit einer isolierenden Schicht, beispielsweise einer Oxidschicht versehen. Nach der Übertragung weist die Silicium-Germanium-Schicht eine Versetzungsdichte von weniger als 1·10⁴ cm⁻² auf.

Soll eine Germanium-Schicht auf eine Trägerscheibe übertragen werden, so wird eine erfindungsgemäße Halbleiterscheibe als Donorscheibe verwendet, die an ihrer Oberfläche eine Schicht aus reinem Germanium trägt, d. h. die einen Stoffmengenanteil des Germaniums von x = 1 hat. Soll insbesondere eine GOI-Scheibe ("germanium on insulator") hergestellt werden, so wird als Trägerscheibe eine elektrisch isolierende Scheibe verwendet oder die Oberfläche der Donorscheibe und/oder der Trägerscheibe wird vor dem Verbinden mit einer isolierenden Schicht, beispielsweise einer Oxidschicht versehen. Nach der Übertragung weist die Germanium-Schicht eine Versetzungsdichte von weniger als 5·10⁵ cm⁻² auf.

Soll eine verspannte Siliciumschicht auf eine Trägerscheibe übertragen werden, so wird eine erfindungsgemäße Halbleiterscheibe als Donorscheibe verwendet, deren Oberfläche eine verspannte Siliciumschicht trägt, die auf einer Silicium-Germanium-Schicht abgeschieden wurde. Diese Silicium-Germanium-Schicht hat einen Stoffmengenanteil x des Germaniums, der die Bedingung 0 < x < 1 erfüllt. Die Oberfläche der Silicium-Germanium-Schicht, auf der die verspannte Siliciumschicht abgeschieden werden soll, ist vorzugsweise relaxiert und hat bevorzugt eine Zusammensetzung von 0,1 < x < 0,9, besonders bevorzugt von 0,1 < x < 0,5. Soll insbesondere eine sSOI-Scheibe ("strained silicon on insulator") hergestellt werden, so wird als Trägerscheibe eine elektrisch isolierende Scheibe verwendet oder die Oberfläche der Donorscheibe und/oder der Trägerscheibe wird vor dem Verbinden mit einer isolierenden Schicht, beispielsweise einer Oxidschicht versehen. Nach der Übertragung weist die verspannte Siliciumschicht eine Versetzungsdichte von weniger als 1·10⁴ cm⁻² auf.

### Beispiel

Eine gereinigte, monokristalline, <001>-orientierte Siliciumscheibe wurde in einen unterdruckfähigen CVD-Reaktor geladen. Bei einem Druck von 1,3·10⁻⁵ Pa und einer Temperatur von 1050 °C wurde der auf der Oberfläche der Siliciumscheibe verbleibende Sauerstoff und der verbleibende Kohlenstoff durch Spülung mit Wasserstoff entfernt. Unter Verwendung von Dichlorsilan (SiH₂Cl₂) wurde bei 900°C und 530 Pa zunächst eine monokristalline Siliciumschicht mit einer Dicke von 50 nm epitaktisch abgeschieden. Als Trägergas wurde Wasserstoff verwendet. Sofort im Anschluss wurde mit der epitaktischen Abscheidung der gradierten Schicht begonnen. Dazu wurde zusätzlich German (GeH₄) in die Prozesskammer geleitet. Der German-Durchfluss wurde bei Beginn der Abscheidung der gradierten Schicht stark (Steigerung des Durchflusses um 8 sccm alle 30 Sekunden) und im weiteren Verlauf immer schwächer (am Ende der Abscheidung: Steigerung des Durchflusses um 1 sccm alle 30 Sekunden) erhöht. Der Dichlorsilan-Durchfluss wurde jeweils um den gleichen Betrag verringert. Bei einer Schichtdicke von 1,5 µm (d/2) betrug der Germanium-Anteil 20 %. Am Ende des Abscheidungsprozesses betrug der Germanium-Anteil in der abgeschiedenen Schicht 30 %. Die Gesamtdicke d der Silicium-Germanium-Schicht betrug 3 µm. Die Versetzungsdichte an der Oberfläche der Schicht lag bei 9·10³ cm⁻².

## Patentansprüche

1. Halbleiterscheibe, umfassend eine monokristalline Siliciumschicht und eine daran angrenzende gradierte Silicium-Germanium-Schicht der Dicke d mit einer Zusammensetzung Si₁₋ₓGeₓ, wobei x für den Stoffmengenanteil des Germaniums steht und für x die Bedingung 0 < x ≤ 1 gilt und wobei x mit zunehmendem Abstand a von der monokristallinen Siliciumschicht größere Werte annimmt, **dadurch gekennzeichnet, dass** zwischen dem Stoffmengenanteil x(d) des Germaniums an der Oberfläche der gradierten Silicium-Germanium-Schicht und dem Stoffmengenanteil x(d/2) des Germaniums in der Mitte des Abstands zwischen der monokristallinen Siliciumschicht und der Oberfläche der gradierten Silicium-Germanium-Schicht folgender Zusammenhang besteht: x(d/2) > 0,5·x(d).

2. Halbleiterscheibe gemäß Anspruch 1, **dadurch gekennzeichnet, dass** der Zusammenhang x(d/2) > 0,6·x(d) besteht.

3. Halbleiterscheibe gemäß einem der Ansprüche 1 oder 2, **dadurch gekennzeichnet, dass** gleichzeitig der Zusammenhang x(d/2) < 0,9·x(d) erfüllt ist.

4. Halbleiterscheibe gemäß Anspruch 3, **dadurch gekennzeichnet, dass** gleichzeitig der Zusammenhang x(d/2) < 0,85·x(d) erfüllt ist.

5. Halbleiterscheibe gemäß einem der Ansprüche 1 bis 4, **dadurch gekennzeichnet, dass** die Halbleiterscheibe eine an die gradierte Silicium-Germanium-Schicht angrenzende zusätzliche Silicium-Germanium-Schicht mit konstantem Stoffmengenanteil des Germaniums aufweist.

6. Halbleiterscheibe gemäß einem der Ansprüche 1 bis 5, **dadurch gekennzeichnet, dass** der Stoffmengenanteil x des Germaniums in der gradierten Silicium-Germanium-Schicht in Form einer stetig differenzierbaren Funktion des Abstands a von der monokristallinen Siliciumschicht ansteigt.

7. Halbleiterscheibe gemäß einem der Ansprüche 1 bis 5, **dadurch gekennzeichnet, dass** der Stoffmengenanteil x des Germaniums in der gradierten Silicium-Germanium-Schicht in Form einer Stufenfunktion des Abstands a von der monokristallinen Siliciumschicht ansteigt.

8. Halbleiterscheibe gemäß einem der Ansprüche 1 bis 7, **dadurch gekennzeichnet, dass** der Stoffmengenanteil x des Germaniums in der gradierten Silicium-Germanium-Schicht in Form einer monoton ansteigenden Funktion des Abstands a von der monokristallinen Siliciumschicht ansteigt.

9. Halbleiterscheibe gemäß einem der Ansprüche 1 bis 7, **dadurch gekennzeichnet, dass** die gradierte Silicium-Germanium-Schicht wenigstens einen Abstandsbereich von der monokristallinen Siliciumschicht aufweist, in dem x mit zunehmendem Abstand von der monokristallinen Siliciumschicht von einem Ausgangswert beginnend abnimmt, ein lokales Minimum aufweist und wieder auf den Ausgangswert ansteigt, oder einen Abstandsbereich, in dem x mit zunehmendem Abstand von der monokristallinen Siliciumschicht von einem Ausgangswert beginnend ansteigt, ein lokales Maximum aufweist und wieder auf den Ausgangswert abfällt.

10. Halbleiterscheibe gemäß einem der Ansprüche 1 bis 8, **dadurch gekennzeichnet, dass** in die gradierte Silicium-Germanium-Schicht wenigstens eine Pufferschicht mit abweichender Zusammensetzung integriert ist.

11. Halbleiterscheibe gemäß Anspruch 10, **dadurch gekennzeichnet, dass** die Pufferschicht mit abweichender Zusammensetzung neben Silicium und Germanium auch Kohlenstoff enthält.

12. Halbleiterscheibe gemäß einem der Ansprüche 1 bis 11, **dadurch gekennzeichnet, dass** die Oberfläche der gradierten Silicium-Germanium-Schicht oder die Oberfläche der Silicium-Germanium-Schicht mit konstantem Stoffmengenanteil des Germaniums eine Versetzungsdichte von weniger als 1·10⁴ cm⁻² aufweist.

13. Halbleiterscheibe gemäß einem der Ansprüche 1 bis 12, **dadurch gekennzeichnet, dass** der Stoffmengenanteil x des Germaniums an der Oberfläche der gradierten Silicium-Germanium-Schicht oder der Silicium-Germanium-Schicht mit konstantem Stoffmengenanteil des Germaniums einen Wert von 0,1 ≤ x ≤ 0,9 hat.

14. Halbleiterscheibe gemäß Anspruch 13, **gekennzeichnet durch** eine an die gradierte Silicium-Germanium-Schicht oder an die Silicium-Germanium-Schicht mit konstantem Stoffmengenanteil des Germaniums angrenzende verspannte Siliciumschicht.

15. Halbleiterscheibe gemäß einem der Ansprüche 1 bis 12, **dadurch gekennzeichnet, dass** der Stoffmengenanteil des Germaniums an der Oberfläche der gradierten Silicium-Germanium-Schicht oder der Silicium-Germanium-Schicht mit konstantem Stoffmengenanteil des Germaniums einen Wert von x = 1 hat.

16. Verfahren zur Herstellung einer Halbleiterscheibe gemäß einem der Ansprüche 1 bis 15, wobei auf einer Halbleiterscheibe umfassend eine monokristalline Siliciumschicht Silicium-Germanium mit einer Zusammensetzung Si₁₋ₓGeₓ, wobei x für den Stoffmengenanteil des Germaniums steht und für x die Bedingung 0 < x ≤ 1 gilt, epitaktisch abgeschieden wird, wobei x mit zunehmender Dicke der abgeschiedenen Schicht größere Werte annimmt, **dadurch gekennzeichnet, dass** sich der Anstieg von x mit zunehmender Dicke der abgeschiedenen Schicht verlangsamt.

17. Halbleiterscheibe umfassend eine Trägerscheibe und eine damit verbundene relaxierte Silicium-Germanium-Schicht mit einer Zusammensetzung Si₁₋ₓGeₓ, wobei x für den Stoffmengenanteil des Germaniums steht und für x die Bedingung 0 < x ≤ 1 gilt, **dadurch gekennzeichnet, dass** die Oberfläche der Silicium-Germanium-Schicht eine Versetzungsdichte von weniger als 1·10⁴ cm⁻² aufweist.

18. Verfahren zur Herstellung einer Halbleiterscheibe gemäß Anspruch 17, wobei eine Halbleiterscheibe gemäß Anspruch 12 als Donorscheibe verwendet wird, die mit einer Trägerscheibe verbunden wird und wobei anschließend die Dicke der Donorscheibe reduziert wird, sodass die monokristalline Siliciumschicht vollständig und die daran angrenzende Schicht bestehend aus Silicium-Germanium teilweise entfernt wird.

19. Halbleiterscheibe umfassend eine Trägerscheibe und eine damit verbundene verspannte Siliciumschicht, **dadurch gekennzeichnet, dass** die Oberfläche der verspannten Siliciumschicht eine Versetzungsdichte von weniger als 1·10⁴ cm⁻² aufweist.

20. Verfahren zur Herstellung einer Halbleiterscheibe gemäß Anspruch 19, wobei eine Halbleiterscheibe gemäß Anspruch 14 als Donorscheibe verwendet wird, die mit einer Trägerscheibe verbunden wird und wobei anschließend die Dicke der Donorscheibe reduziert wird, sodass die monokristalline Siliciumschicht und die Silicium-Germanium-Schicht vollständig entfernt werden.

21. Halbleiterscheibe umfassend eine Trägerscheibe und eine damit verbundene Germanium-Schicht, **dadurch gekennzeichnet, dass** die Oberfläche der Germanium-Schicht eine Versetzungsdichte von weniger als 5·10⁵ cm⁻² aufweist.

22. Verfahren zur Herstellung einer Halbleiterscheibe gemäß Anspruch 21, wobei eine Halbleiterscheibe gemäß Anspruch 15 als Donorscheibe verwendet wird, die mit einer Trägerscheibe verbunden wird und wobei anschließend die Dicke der Donorscheibe reduziert wird, sodass die monokristalline Siliciumschicht und die daran angrenzende Schicht bestehend aus Silicium-Germanium vollständig entfernt wird, sodass nur mehr die aus Germanium bestehende Schicht auf der Trägerscheibe verbleibt.
